(19) Europäisches Patentamt
European Patent Office
Office européen des brevets

(11) **EP 1 293 938 B1**

(12) **EUROPÄISCHE PATENTSCHRIFT**

(45) Veröffentlichungstag und Bekanntmachung des Hinweises auf die Patenterteilung:
**05.09.2007 Patentblatt 2007/36**

(51) Int Cl.:
*G07C 9/00* (2006.01)     *H03K 21/40* (2006.01)
*H03M 7/16* (2006.01)

(21) Anmeldenummer: **02102325.4**

(22) Anmeldetag: **06.09.2002**

(54) **Binärzähler mit permutierten Speicherung**

Binary counter with permuted storage

Compteur binaire avec stockage permuté

(84) Benannte Vertragsstaaten:
**AT BE BG CH CY CZ DE DK EE ES FI FR GB GR IE IT LI LU MC NL PT SE SK TR**

(30) Priorität: **07.09.2001 DE 10144077**

(43) Veröffentlichungstag der Anmeldung:
**19.03.2003 Patentblatt 2003/12**

(73) Patentinhaber: **NXP B.V.**
**5656 AG Eindhoven (NL)**

(72) Erfinder: **Böh, Frank**
**52088, Aachen (DE)**

(74) Vertreter: **Volmer, Georg et al**
**Philips Intellectual Property & Standards GmbH,**
**Postfach 50 04 42**
**52088 Aachen (DE)**

(56) Entgegenhaltungen:
**US-A- 4 663 770**     **US-A- 5 300 930**
**US-A- 5 450 460**     **US-A- 5 675 622**
**US-A- 6 084 935**

**Beschreibung**

Die Erfindung betrifft eine Anordnung zur Realisierung eines Binärzählers, der ein in einem nichtflüchtigen Speicher gespeichertes Datenwort inkrementiert oder dekrementiert, wobei die Anordnung einen Zähler und einen Arbeitsspeicher aufweist.

Derartige nach dem Stande der Technik bekannte Anordnungen arbeiten so, daß ein in dem nichtflüchtigen Speicher gespeichertes Datenwort aus diesem ausgelesen und in einen Arbeitsspeicher übertragen wird. Dort wird das Datenwort durch binäres Addieren der Zahl 1 (oder einer anderen Zahl) inkrementiert und so der Zählerstand des Wortes erhöht. Das Datenwort mit dem erhöhten Zählerstand wird in den nichtflüchtigen Speicher zurückgeschrieben. Dekrementierung um 1 oder eine andere Zahl ist auch möglich.

Derartige Anordnungen werden beispielsweise für Funkschlüsed-Systeme für Fahrzeuge eingesetzt, bei dem der binäre Wert des Zählers mit kryptographischen Methoden verschlüsselt und von dem Funkschlüssel auf das Fahrzeug übertragen wird. Da der Funkschlüssel typischerweise batteriebetrieben und die Batterie auswechselbar ist, wird der Zählerstand des Datenwortes in einem EEPROM gespeichert, dessen Inhalt auch bei einem Batteriewechsel nicht verloren geht.

Hierbei besteht jedoch das Problem, daß sich insbesondere die niederwertigsten Bits des Datenwortes mit jedem Dekrementieren oder Inkrementieren des Zählerstandes des Datenwortes ändern, so daß mit jedem neuen Zählerstand alle Bits des Datenwortes neu in das EEPROM zu schreiben sind. Hierdurch entsteht eine relativ hohe Belastung der Speicherzellen, die bei einem EEPROM typischerweise nur eine begrenzte Zahl von Schreibzyklen zulassen, d. h. deren Lebensdauer durch die Zahl der Schreibzyklen bestimmt wird.

Aus US5450460 ist eine Zählerschaltung bekannt, mit einem in zwei Zellenreihen unterteilten nichtflüchtigen Speicher.

In US6084935 wird eine digitale Zählerschaltung beschrieben, bestehend aus einer Mehrzahl von Bitspeicherelementen zum Speichern eines Zählwertes und einer mit dieser Mehrzahl von Bitspeicherelementen verbundenen Zustandlogik, zum Berechnen eines nächsten Zustandes dieser Mehrzahl von Bitspeicherelementen, worin diese Zustandlogik jedes Element dieser Mehrzahl von Bitspeicherelementen im wesentlichen gleich häufig ändert, bevor dieser Zählwert sich wiederholt.

Es ist Aufgabe der Erfindung, eine Anordnung der Eingangs genannten Art anzugeben, welche eine möglichst geringe Zahl von Schreibzyklen in das EEPROM erforderlich macht.

Diese Aufgabe ist erfindungsgemäß dadurch gelöst, daß die Anordnung zur Realisierung eines Binärzählers, zum De-oder Inkrementieren eines in einem nichtflüchtigen Speicher gespeicherten teilweise permutierten Datenwortes, mit einem Zähler und einem Arbeitsspeicher, wobei ein Datenwort in dem nichtflüchtigen Speicher in wenigstens zwei Speicherworten gespeichert ist, wobei die Anordnung für eine De-oder Inkrementierung eines in dem nichtflüchtigen Speicher gespeicherten Datenwortes so gestaltet ist, dass sie

- die Speicherworte des Datenwortes aus dem nichtflüchtigen Speicher ausliest, in dem Arbeitsspeicher ablegt und dabei eine inverse Umordnung von k Permutationsbits des Datenwortes vornimmt,
- eine inverse bijektive Abbildungsfunktion auf die k Permutationsbits des Datenwortes anwendet,
- das Datenwort de oder inkrementiert,
- eine bijektive Abbildungsfunktion auf die k Permutationsbits des Datenwortes anwendet,
- eine Umordnung der k Permutationsbit vornimmt,
- und für jedes Speicherwort prüft, ob sich dieses von dem in dem nichtflüchtigen Speicher gespeicherten Speicherwort unterscheidet und nur diejenigen Speicherworte neu in dem nichtflüchtigen Speicher speichert, für die dies der Fall ist,

wobei die bijektive Abbildungsfunktion so ausgelegt ist, daß sich die k niederwertigsten Bits des Datenwortes, die die k Permutationsbits darstellen, auf die die Abbildungsfunktion angewendet wird, nach Anwenden der Abbildungsfunktion in Folge der De- oder Inkrementierung möglichst selten und etwa gleich häufig ändern, und wobei die Umordnung so vorgenommen wird, daß die k Permutationsbits des Datenwortes im Arbeitsspeicher auf k Speicherworte im flüchtigen Speicher verteilt werden.

Kemidee der Erfindung ist, das Datenwort in dem Speicher nicht als solches, d h in unveränderter Form, sondern in teilweise permutierter Form und mit umgeordneten Bits abzuspeichern. Permutiert bedeutet dabei, daß k Permutationsbits des Datenwortes einer bijektiven Abbildungsfunktion unterworfen werden und in dieser permutierten Form in dem nichtflüchtigen Speicher gespeichert werden. Dabei ist diese bijektive Abbildungsfunktion so ausgelegt, daß sich von den k Permutationsbits, auf die die Abbildungsfunktion angewendet wird, nach Anwenden der Abbildungsfunktion infolge der De- oder Inkrementierung jedes für sich möglichst selten ändert und daß alle Permutationsbits sich etwa gleich häufig ändern.

Diese k Permutationsbits, die der bijektiven Abbildungsfunktion unterzogen worden sind, werden auf k Speicherworte verteilt. Speicherworte sind hier diejenigen Worte in dem nichtflüchtigen Speicher, auf die das Datenwort aufgeteilt ist.

Durch eine derartige Anwendung der bijektiven Abbildungsfunktion und durch die Umordnung der permutierten k Permutationsbits wird erreicht, daß sich die Speicherworte des Datenwortes etwa gleich häufig ändern und insbesondere daß sich mit jedem De- oder Inkrementierungsvorgang nicht jedes der Speicherworte ändert. Tatsächlich ist die bijektive Abbildungsfunktion so ausgelegt, daß sich infolge der De- oder Inkrementierungsvorgänge statistisch gesehen jedes der Speicherworte des Datenwortes etwa gleich häufig ändert.

Dies bedeutet jedoch, daß nach jedem De- oder Inkrementierungswrgang sich nur etwa 1 Speicherwort ändert. Die übrigen Speicherworte bleiben unverändert. Daher wird beim Zurückschreiben des Datenwortes nach Anwendung der bijektiven Abbildungsfunktion überprüft, welche Speicherworte in dem Arbeitsspeicher sich von dem entsprechenden Speicherwort in dem nichtflüchtigen Speicher unterscheiden. Dies wird im Regelfall nur 1 Speicherwort sein. Es wird dann beim Zurückschreiben des de oder inkrementierten Datenwortes, in dem die Permutationsbits der bijektiven Abbildungsfunktion unterzogen und umgeordnet worden sind, nur dasjenige Speicherwort tatsächlich zurückgeschrieben, das sich gegenüber dem in dem nicht flüchtigen Speicher noch abgespeichertem Speicherwort tatsächlich verändert hat.

Somit wird erreicht, daß nach jedem De- oder Inkrementiervorgang nur 1 Speicherwort des Datenwortes tatsächlich in den nichtflüchtigen Speicher zurückgeschrieben werden muß und das diese Schreibvorgänge über alle Speicherworte des Datenwortes statistisch etwa gleich verteilt sind. Damit wird die Zahl der Schreibvorgänge, bezogen auf die einzelnen Worte des nichtflüchtigen Speichers erheblich reduziert. Insbesondere werden alle Zellen gleich belastet.

Damit können statistisch gesehen bei zB. 4 Speicherworten etwa 4 mal so viele De- oder Inkrementierungsvorgänge durchgeführt und die entsprechend veränderten Datenworte in den nichtflüchtigen Speicher geschrieben werden, wie bei dem Stande der Technik.

Die Umordnung der Permutationsbits in Speicherworten kann im einfachsten Falle so vorgenommen werden, daß freie, in den Speicherworten vorgesehene Positionen dazu eingesetzt werden, in diese die Permutationsbits zu verschieben. Damit wird jedoch die Bitbreite der Speicherworte durch die Permutationsbits zusätzlich belastet. Um dies zu vermeiden, ist nach einer Ausgestaltung der Erfindung nach Anspruch 2 vorgesehen, daß die Permutationsbits ihre Position mit anderen, in den Speicherworten vorgesehenen Bits tauschen. Damit tritt durch die Permutationsbits kein zusätzlicher Speicherbedarf ein.

Die Zählschrittweite beim De- oder Inkrementieren kann in Prinzip eine beliebige Zahl betragen. Nach einer weiteren Ausgestaltung der Erfindung nach Anspruch 3 ist jedoch vorgesehen, daß die Schrittweite 1 beträgt und das die Zahl k der Permutationsbits gleich der Zahl der Speicherworte eines Datenwortes ist.

In dem Falle, daß die Zählschrittweite beim De-oder Inkrementieren gleich 1 ist, wird ein optimales Ergebnis bereits dann erreicht, wenn genau so viele Permutationsbits wie Speicherworte des Datenwortes vorgesehen sind. Weist beispielsweise das Datenwort 4 Speicherworte auf, so wird ein optimales Ergebnis bereits dann erreicht, wenn in dem Datenwort die 4 niederwertigsten Bits als Permutationsbits vorgesehen sind.

Die oben beschriebenen Eigenschaften der bijektiven Abbildungsfunktion werden dann erreicht, wenn, wie nach einer weiteren Ausgestaltung der Erfindung nach Anspruch 5 sich mit jedem De- oder Inkrementiervorgang nach Anwendung der bijektiven Abbildungsfunktion auf die Permutationsbits nur jeweils 1 Bit ändert. Dies wiederum bedeutet, daß sich nur 1 Speicherwort gegenüber dem vorherigen Zählerstand ändert und auch nur dieses Speicherwort neu in den nichtflüchtigen Speicher geschrieben wenden muß.

Die bijektive Abbildungsfunktion kann gemäß einer weiteren Ausgestaltung der Erfindung vorteilhaft so realisiert sein, daß eine Tabelle angelegt ist, in der die 4 Permutationsbit in nicht permutierter Form gespeichert sind. Für die 4 sich dort quasi ergebenden Datenworte, die nicht mit den Zählerdatenworten identisch sind, kann in der Tabelle jeweils 1 Datenwort von 4 Permutationsbits in permutierter Form angegeben sein. Somit kann die Anwendung der bijektiven Abbildungsfunktion (Permutation) durch Anwendung dieser Tabelle vorgenommen werden.

Die bijektive Abbildungsfunktion kann grundsätzlich durch Probieren gewonnen werden. Sie ist dabei so auszulegen, daß in den k Permutationsbits durch Anwendung der bijektiven Abbildungsfunktion beim De- oder Inkrementieren sich jeweils nur 1 Bit ändert. Eine vorteilhafte Methode zur Gewinnung der bijektiven Abbildungsfunktion gemäß einer weiteren Ausgestaltung der Erfindung nach Anspruch 7 ist dadurch gekennzeichnet, daß eine Suchbaumstrategie eingesetzt wird. In einem derartigen Suchbaum werden pro Ebene immer die k Permutationsbits in permutierter Form als Permutationswort eingetragen. In dem Suchbaum werden neue Ebenen jeweils dadurch gebildet, daß ausgehend von einem Permutationswort mit den k Permutationsbits, ein neues Permutationswort mit k Permutationsbits eingetragen wird, wobei sich in der neuen Ebene jedoch nur eines dieser Bits verändert hat. Auf diese Weise können in dem Suchbaum Zweige gebildet werden, wobei sich entlang dieser Zweige in den k Permutationsbits pro Ebene immer nur 1 Bit ändert. Dabei muß darauf geachtet werden, daß diejenigen in den Ebenen neu eingetragenen Permutationsworte der k Permutationsbits gestrichen werden, die in höheren Ebenen bereits vorgekommen sind. Ferner muß in den Zweigen des Suchbaumes die Änderungshäufigkeit für jedes Bit der k Permutationsbits notiert werden, da sich jedes Bit der k Permutationsbits in einem vollständigen Zweig des Suchbaums nur k mal ändern darf.

Wird auf diese Weise ein Suchbaum gebildet, so werden einige Zweige von vornherein, da die o. g Bedingungen für sie nicht eingehalten werden, früh enden. Es wird aber auch Zweige geben, in denen alle denkbaren $2^k$ Ebenen gebildet werden können. Diese Zweige, für die alle Bedingungen eingehalten werden, enthalten entlang des Zweiges eine Folge von Datenworten, die als Permutationsworte der k Permutationsbits einsetzbar sind Es wird dann für die k Permutationsbits in den Permutationsworten, beispielsweise anhand einer Tabelle, festgelegt, wie die k Permutationsbits der Permutationsworte, die de- oder inkrementiert wurden, auf die Bits der Permutationsdatenworte bei Anwendung der bijektiven Anwendungsfunktion übertragen werden.

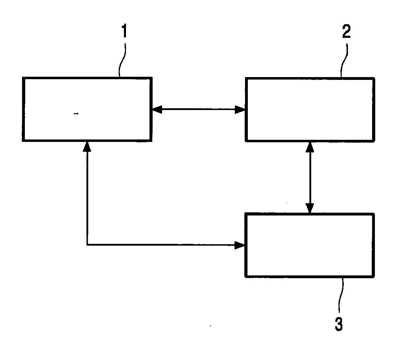

Nachfolgend wird ein Ausführungsbeispiel der Erfindung anhand der einzigen Figur der Zeichnung näher erläutert.

Die Figur zeigt in Form eines schematischen Blockschaltbildes eine erfindungsgemäße Anordnung mit einem nichtflüchtigen Speicher 1.

In dem nichtflüchtigen Speicher 1, bei dem es sich um ein EEPROM handelt, ist ein Datenwort gespeichert, welches de- oder inkrementiert werden soll. Bei der De- oder Inkrementierung kann ein Zählvorgang im Prinzip mit einer beliebigen Schrittweise vorgenommen werden, meist jedoch mit der Schrittweite 1. Im folgenden soll davon ausgegangen werden, daß ein in dem Speicher 1 gespeichertes Datenwort eine Bitbreite von 32 Bit aufweist und in dem nichtflüchtigen Speicher 1 in 4 Speicherworten mit je 8 Bit abgespeichert ist. Ferner soll im Folgenden davon ausgegangen werden, daß mit jedem Zählvorgang, der noch zu erläutern sein wird, eine Inkrementierung des Datenwortes mit einer Schrittweite gleich 1 vorgenommen wird. Es wird also mit jedem Inkrementierungsvorgang dem Datenwort die digitale Zahl 1 hinzuaddiert.

Um einen derartigen Zählvorgang zu ermöglichen, ist in der Anordnung gemäß der Figur ein Arbeitsspeicher 2 vorgesehen. Ferner ist eine Steuerung 3 vorgesehen, bei der es sich vorzugsweise um einen Mikroprozessor handelt.

Bei Anordnungen nach dem Stande der Technik wird das Inkrementieren des in dem nichtflüchtigen Datenspeichers 1 gespeicherten Datenwortes dadurch realisiert, daß das Datenwort aus dem nichtflüchtigen Speicher 1 in den Arbeitsspeicher 2 übertragen, dort inkrementiert und anschließend wieder in den nichtflüchtigen Speicher 1 zurückgeschrieben wird. Dieser Vorgang wird durch die Steuerung 3 gesteuert.

Dabei ist deutlich, daß nach jedem Inkrementiervorgang in dem Arbeitsspeicher 2 bei diesen Lösungen nach dem Stand der Technik das Problem auftritt, daß sich die Bits desjenigen Speicherwortes, in welchem die niederstwertigen Bits des Datenwortes enthalten sind, nach jedem Inkrementiervorgang ändern, so daß auf jeden Fall dieses Speicherwort nach jedem Inkrementiervorgang neu in den nichtflüchtigen Speicher 1 geschrieben werden muß.

Dabei tritt das Problem auf, daß nichtflüchtige Speicher, beispielsweise EEPROMs, nur eine begrenzte Anzahl von Schreibzyklen gestatten. Es besteht daher das Ziel, die Schreibzyklen für einen nichtflüchtigen Speicher pro Speicherzelle möglichst niedrig zu halten.

Daher ist in der erfindungsgemäßen Anordnung vorgesehen, die k niederstwertigen Bits des Datenwortes vor dem Zurückschreiben von dem Arbeitsspeicher 2 in den nichtflüchtigen Speicher 1 einer bijektiven Abbildungsfunktion zu unterziehen und diese Bits in den in dem Ausführungbeispiel 4 Speicherworten des Datenwortes gleichmäßig zu verteilen. Wie noch zu erläutern sein wird, wird damit erreicht, daß in den Datenworten mit den bereits permutierten Permutationsbits sich pro Inkrementierungsvorgang nur jeweils 1 Speicherwort dert. Beim Zurückschreiben des Datenwortes mit den 4 Speicherworten, die die bereits permutierten Permutationsbits enthalten, in den nichtflüchtigen Speicher 1 wird mittels der Steuerung 3 überprüft, welche dieser Speicherworte, die zunächst noch in dem Arbeitsspeicher 2 gespeichert sind, sich gegenüber den in dem nichtflüchtigen Speicher 1 gespeicherten Speicherworten unterscheiden. Nur diejenigen Speicherworte, die sich verändert haben, werden neu in den nichtflüchtigen Speicher 1 geschrieben.

Da die bijektive Abbildungsfunktion so ausgelegt ist, daß die Permutationsbits nach Durchführung des Inkrementiervorgangs und nach Anwendung der bijektiven Abbildungsfunktion auf die Permutationsbits sich möglichst selten ändern und im Vergleich zueinander etwa alle gleich häufig ändern, wird erreicht, daß bei einem Rückschreibvorgang aus dem Arbeits-speicher 2 in den nichtflüchtigen Speicher 1 in dem Ausführungsbeispiel mit 4 Speicherworten je 8 Bit pro Inkrementierungsvorgang nur etwa 1 Speicherwort neu in den nichtflüchtigen Speicher zu schreiben ist. Außerdem sind statistisch gesehen von diesem Rückschreibvorgang alle 4 Speicherworte gleich häufig betroffen. da sich die Permutationsbits in ihrer permutierten Form etwa alle gleich häufig ändern, wird außerdem erreicht, daß die 4 Speicherworte etwa gleich häufig von dem Rückschreibvorgang betroffen sind

Im Detail ist die Arbeitsweise der erfindungsgemäßen Anordnung gemäß der Figur wie folgt:

In dem nichtflüchtigen Speicher 1 ist das zu inkrementierende Datenwort mit den 4 permutierten Permutationsbits gespeichert. Zur Durchführung einer Inkrementierung des Datenwortes wird dieses aus dem nichtflüchtigen Speicher 1 in den Arbeitsspeicher 2 geladen. Die Permutationsbits, die innerhalb des Datenwortes an neue Positionen verschoben worden sind, werden wieder an ihre Ausgangspositionen verschoben und es wird eine inverse bijektive Abbildungsfunktion eingesetzt, so daß die permutierten Permutationsbits wieder in ihre nicht-permutierten Ausgangswerte zurückgewandelt werden. Es steht dann in dem Arbeitsspeicher wieder das Datenwort in unveränderter, d h nicht teilweise permutierter und umgeordneter Form, zur Verfügung. Dieses Datenwort kann dann in dem Arbeitsspeicher 2 mittels der Steuerung 3 inkrementiert werden. Nach diesem Inkrementiervorgang werden in dem Ausführungsbeispiel 4 Permutationsbits des Datenwortes einer bijektiven Abbildungsfunktion, auf die noch näher einzugehen sein wird, unterworfen. Bei diesen 4 Permutationsbits handelt es sich um die 4 niederwertigsten Bits des Datenwortes. Nach diesem Permutationsvorgang werden die 4 permutierten Permutationsbits auf die 4 Speicherworte gleichmäßig verteilt, d h. jedes der Permutationsbits wird in eines der Speicherworte verschoben. Dabei kann vorteilhaft ein Austausch mit anderen Bits, die an den entsprechenden Positionen der Speicherworte standen, vorgenommen werden.

Nach diesem Umordnungsvorgang befindet sich somit in jedem Speicherwort 1 Permutationsbit. Infolge der Auslegung der bijektiven Abbildungsfunktion ändert sich jedes dieser Permutationsbits in dem Ausführungsbeispiel etwa nach jedem 4. Inkrementierungsvorgang. Da diese 4 Permutationsbits die niederwertigsten Bits des Datenwortes sind und somit diejenigen, die sich am häufigsten ändern, wird durch die 4 permutierten Permutationsbits, die auf die 4 Speicherworte verteilt worden sind, die Änderungshäufigkeit der Speicherworte bestimmt. Da wiederum die 4 Permutationsbits sich alle etwa gleich häufig ändern, und zwar mit etwa jedem 4. Inkrementierungsvorgang, wird für die 4 Speicherworte erzielt, daß nach jedem Inkrementierungsvorgang sich nur etwa eines der 4 Speicherworte ändert und daß diese Änderungshäufigkeit auf die 4 Speicherworte gleich verteilt ist.

Um nun tatsächlich eine Reduzierung der Schreibvorgänge in dem nichtflüchtigen Speicher 1 zu erreichen, wird vor dem Zurückschreiben der Speicheiworte, in denen sich die Permutationsbits in permutierter Form befinden, überprüft, ob sich diese Speicherworte gegenüber den Speicherworten, die von dem vorherigen Inkrementierungsvorgang noch in dem nichtflüchtigen Speicher 1 abgespeichert sind, tatsächlich verändert haben. Ein Rückschreibvorgang der neugebildeten Speicherworte im Arbeitsspeicher 2 in den nichtflüchtigen Speicher 1 findet nur für diejenigen Speicherworte statt, die sich tatsächlich verändert haben. Aus den oben erläuterten Gründen wird daher nach jedem Zählvorgang statistisch gesehen nur jeweils eines der 4 Speicherworte in die nichtflüchtigen Speicher 1 zurückgeschrieben werden müssen. Damit wird, bezogen auf die einzelnen Speicherzellen des nichtflüchtigen Speichers 1, eine Reduzierung der Schreibvorgänge etwa um den Faktor 4 gegenüber den Lösungen nach dem Stande der Technik erzielt. Damit wird eine Verlängerung der Lebensdauer des nichtflüchtigen Speichers 1 um eben diesen Faktor erzielt; bzw. anders formuliert können, bezogen auf einen Lebenszyklus des nichtflüchtigen Speichers 1 etwa 4 mal so viele Inkrementierungswrgänge stattfinden.

Im folgenden soll anhand einiger mathematischer Darstellungen der Vorgang der Permutation und der Umordnung nochmals erläutert werden:

Die Gleichung (1)

$$C = [C_{31}\ C_{30}\ C_{29}\ C_{28}\ C_{27}\ C_{26}\ C_{25}\ C_{24}\ C_{23}\ C_{22}\ C_{21}\ C_{20}\ C_{19}\ C_{18}\ C_{17}\ C_{16}$$
$$C_{15}\ C_{14}\ C_{13}\ C_{12}\ C_{11}\ C_{10}\ C_9\ C_8\ C_7\ C_6\ C_5\ C_4\ C_3\ C_2\ C_1\ C_0\ ] \tag{1}$$

zeigt ein Datenwort mit 32 Bits, wie es sich beispielsweise in dem Arbeitsspeicher 2 befinden kann. Dabei ist dieses Datenwort nicht permutiert bzw. genauer gesagt, es sind keine Bits des Datenwortes permutiert. Dieses Datenwort C ist dasjenige, dessen Wert inkrementiert werden soll. Das Bit $C_0$ ist das niederstwertige Bit; das Bit $C_{31}$ das höchstwertige Bit. Mit jedem Zählvorgang ändert sich wenigstens das niederwertigste Bit $C_0$. Die Änderungshäufigkeit der einzelnen Bits ist von dem höchstwertigen Bit $C_{31}$ zu dem niederstwetigen Bit $C_0$ hin ansteigend. Dies bedeutet, daß sich die niederstwertigen Bits am häufigsten ändern. Da das Datenwort C gemäß Gleichung 1 nach dem Inkrementieren jeweils in den nichtflüchtigen Speicher 1 gemäß der Figur zurückzuschreiben ist, ergibt sich also für dasjenige Speicherwort, das die niederstwertigen Bits enthält, eine sehr hohe Schreibbelastung, da sich die niederstwertigen Bits nach jedem Inkrementiervorgang ändern und somit jedes Mal ein Schreibvorgang in den nichtflüchtigen Speicher 1 erforderlich ist. Um eben dieses Problem zu vermeiden, weist die erfindungsgemäße Anordnung eine Permutation und Umordnung auf.

In dem Ausführungsbeispiel wird das Datenwort C gemäß Gleichung 1 beim Rückschreiben in den nichtflüchtigen Speicher 1 in 4 Speicherworte aufgeteilt. Um für diese 4 Speicherworte eine etwa gleiche Änderungshäufigkeit zu erzielen, werden in dem Datenwort gemäß Gleichung 1 die 4 niederstwertigen Bits einer bijektiven Abbildungsfunktion unterworden, werden also permutiert. Die Gleichung 2 gibt dies in allgemeiner Form für k zu permutierende Bits an:

$$p(C_{k-1} \, C_{k-2 \, \ldots} \, C_1 \, C_0) = (P_{k-1} \, P_{k-2 \, \ldots} \, P_1 \, P_0) \qquad (2)$$

$(k = Anzahl \; zu \; permutierender \; Bits)$

In dem Ausführungebeispiel soll k =4 betragen, da das Datenwort in 4 Speicherworte aufgeteilt wird und bei 4 Speicherworten 4 Permutationsbits bereits ein optimales Ergebnis liefern:

$$p(C_3 \, C_2 \, C_1 \, C_0) = (P_3 \, P_2 \, P_1 \, P_0) \qquad (3)$$

Der Permutationsvorgang findet erst nach Inkrementierung des Zählerwortes statt. Die Gleichung 4

$$C' = [ \; C_{31} \, C_{30} \, C_{29} \, C_{28} \, C_{27} \, C_{26} \, C_{25} \, C_{24} \, C_{23} \, C_{22} \, C_{21} \, C_{20} \, C_{19} \, C_{18} \, C_{17} \, C_{16} \\ C_{15} \, C_{14} \, C_{13} \, C_{12} \, C_{11} \, C_{10} \, C_9 \, C_8 \, C_7 \, C_6 \, C_5 \, C_4 \, P_3 \, P_2 \, P_1 \, P_0 \; ]$$

$$(4)$$

zeigt die 4 Permutationsbits $P_0$ bis $P_3$, die durch die Anwendung einer bijektiven Abbildungsfunktion nach dem Inkrementieren des Datenwortes auf die 4 Bits $C_0$ bis $C_3$ des tenmortes C entstanden sind Die bijektive Abbildungsfunktion ist dabei so ausgelegt, daß sich die 4 Permutationsbits $P_0$ bis $P_3$ in permutierter Form infolge der Inkrementiervorgänge jeweils etwa gleich häufig ändern. In diesem Ausführungsbeispiel mit 4 Permutationsbits bedeutet dies, daß sich nach jedem Zählvorgang des Datenwortes C und Anwendung der bijektiven Abbildungsfunktion auf die 4 Bits $C_0$ bis $C_3$ des Datenwortes C, wodurch sich das permutierte Datenwort C' ergibt, in dem sich die Permutationsbits in permutierter Form befinden, sich von den 4 Permutationsbits $P_0$ bis $P_3$ statistisch gesehen etwas nur eines ändert.

Somit ist erreicht worden, daß die 4 niederwertigsten Bits in dieser permutierten Form etwa gleiche Änderungshäufigkeiten aufweisen.

Um diese Eigenschaft der 4 Permutationsbits optimal zu nutzen, werden die 4 Permutationsbits $P_0$ bis $P_3$ auf die 4 Speicherworte des Datenwortes aufgeteilt, d h es wird in jedes der 4 Speicherworte jeweils 1 permutiertes Permutationsbit gesetzt.

Im Ergebnis entsteht dabei eine neue Struktur von Speicherworten $E'_0$ bis $E'_3$ gemäß Gleichung 5

$$E'_0 = [ \, E_{31} \; E_{30} \; E_{29} \; E_{28} \; E_{27} \; E_{26} \; E_{25} \; P_3 \, ]$$
$$E'_1 = [ \, E_{23} \; E_{22} \; E_{21} \; E_{20} \; E_{19} \; E_{18} \; E_{17} \; P_2 \, ] \qquad (5)$$
$$E'_2 = [ \, E_{15} \; E_{14} \; E_{13} \; E_{12} \; E_{11} \; E_{10} \; E_9 \; P_1 \, ]$$
$$E'_3 = [ \, E_7 \; E_6 \; E_5 \; E_4 \; E_{24} \; E_{16} \; E_8 \; P_0 \, ]$$

Die Gleichung 5 zeigt, daß jedes der 4 Speicherworte $E'_0$ bis $E'_3$ jeweils 1 Permutationsbit $P_0$, $P_1$, $P_2$ oder $P_3$ enthält. Dabei sind die Permutationsbits an Positionen anderer Bits verschoben worden, die wiederum an die Ausgangsposition der Permutationsbits verschoben worden sind Es hat also ein Austausch der Positionen dieser Bits stattgefunden. In der Gleichung 5 ist dieses in dem Speicherwort $E'_3$ erkennbar, in dem die Bits $E_8$, $E_{16}$, $E_{24}$, die ursprünglich in den Speicherworten $E_0$, $E_1$ und $E_2$ standen, infolge der Umordnung nun in dem Speichefwort $E'_3$ stehen.

Durch diese Permutation und Umordnung der permutierten Bits $P_0$ bis $P_3$ haben die 4 Speicherworte $E'_0$ bis $E'_3$-gemäß Gleichung 5 die Eigenschaft, sich nach jedem Inkrementierungsvorgang nach dem Anwenden der bijektiven Abbildungsfunktion und nach dem anschließenden Umordnen, also in der Form in der sie gemäß Gleichung 5 dargestellt sind, etwa gleich häufig zu ändern.

Das aus den 4 Speicherworten gemäß Gleichung 5 gebildete Datenwort ist nach diesen Vorgängen wieder in den nichtflüchtigen Speicher 1 gemäß der Figur zurückzuschreiben. Aufgrund der oben erläuterten Eigenschaften der Speicherworte $E'_0$ bis $E'_3$ wird sich statistisch gesehen jedoch nur eines dieser Speicherworte gegenüber dem vorigen in dem nichtflüchtigen Speicher 1 gespeicherten Zählerstand gespeicherten Speicherworte verändern. Bei dem Rückshreibvorgang wird daher nur dasjenige Speicherwort E'$_0$, E'$_1$ E'$_2$ oder E$_3$ in dem nichtflüchtigen Speicher 1 zurückgeschrieben, das sich tatsächlich verändert hat.

Damit wird im Ergebnis eine Reduzierung der Schreibvorgänge um den Faktor 4 und damit eine entsprechende Verlängerung der Lebensdauer des nichtflüchtigen Speichers 1 erreicht.

Nach diesem Schreibvorgang befindet sich also in dem nichtflüchtigen Speicher 1 das neue Datenwort, in dem sich gegebenenfalls nur 1 Speicherwort verändert hat. Dieses Datenwort befindet sich dort jedoch in permutierter Form, d h in der Form, in der die 4 Permutationsbits in permutierter Form auftauchen. Ferner sind diese Bits umgeordnet. Für den nächsten Zählvorgang in dem Arbeitsspeicher 2 ist dieses Datenwort aus dem nicht flüchtigen Speicher 1 auszulesen und vor Durchführung des Inkrementierungsvorganges sind die Permutationsbits wieder in ihre ursprüngliche Position zu verschieben. Entsprechendes gilt selbsrverständlich für diejenigen Bits, die ihre Position mit den Permutationsbits vertauscht hatten. Ferner ist die Permutation der 4 Permutationsbits P$_0$ bis P$_3$ durch Anwendung der inversen bijektiven Abbildungsfunktion wieder rückgängig zu machen, so daß wieder die niederwertigsten Bits C$_0$ bis C$_3$ in ihrer ursprünglichen Form in dem Arbeitsspeicher 2 stehen. Erst dann kann der Inkrementierungworgang des Datenwortes in den Arbeitsspeicher 2 mittels der Steuerung 3 durchgeführt werden. Nach Durchführung des Inkrementierungsvorganges steht wieder ein neues Datenwort C in dem Arbeitsspeicher 2, für das sich die erläuterten Vorgänge wiederholen.

Im folgenden sollen die Eigenschaften der bijektiven Abbildungsfunktion (auch als Permutation bezeichnet) näher erläutert werden. Dies soll anhand folgender Tabelle 1 geschehen:

Tabelle 1

| C$_3$ | C$_2$ | C$_1$ | C$_0$ | | P$_3$ | P$_2$ | P$_1$ | P$_0$ |
|---|---|---|---|---|---|---|---|---|
| 0 | 0 | 0 | 0 | <=> | 0 | 0 | 0 | 0 |
| 0 | 0 | 0 | 1 | <=> | 0 | 0 | 0 | 1 |
| 0 | 0 | 1 | 0 | <=> | 0 | 0 | 1 | 1 |
| 0 | 0 | 1 | 1 | <=> | 0 | 0 | 1 | 0 |
| 0 | 1 | 0 | 0 | <=> | 0 | 1 | 1 | 0 |
| 0 | 1 | 0 | 1 | <=> | 0 | 1 | 1 | 1 |
| 0 | 1 | 1 | 0 | <=> | 1 | 1 | 1 | 1 |
| 0 | 1 | 1 | 1 | <=> | 1 | 0 | 1 | 1 |
| 1 | 0 | 0 | 0 | <=> | 1 | 0 | 0 | 1 |
| 1 | 0 | 0 | 1 | <=> | 1 | 1 | 0 | 1 |
| 1 | 0 | 1 | 0 | <=> | 0 | 1 | 0 | 1 |
| 1 | 0 | 1 | 1 | <=> | 0 | 1 | 0 | 0 |
| 1 | 1 | 0 | 0 | <=> | 1 | 1 | 0 | 0 |
| 1 | 1 | 0 | 1 | <=> | 1 | 1 | 1 | 0 |
| 1 | 1 | 1 | 0 | <=> | 1 | 0 | 1 | 0 |
| 1 | 1 | 1 | 1 | <=> | 1 | 0 | 0 | 0 |

Die ersten 4 Spalten der Tabelle zeigen die 4 niederstwertigen Bits des Datenwortes gemäß Gleichung 1. Hierbei ist wie gesagt davon ausgegangen worden, daß die Inkrementierung mit einer Zählerschrittweite 1 erfolgt. Die ersten 4 Spalten der Tabelle zeigen, wie die 4 niederstwertigen Bits C$_0$ bis C$_3$ hochgezählt werden. Diese 4 niederstwertigen Bits sind diejenigen innerhalb des Datenwortes C gemäß Gleichung 1, die sich am häufigsten ändern und somit die Schreibhäufigkeit in den nichtflüchtigen Speicher 1 bestimmen.

Die 4 rechten Spalten in der Tabelle zeigen die 4 Permutationsbits in permutierter Form als P$_0$ bis P$_3$. Die Tabelle ist dabei so zu verstehen, daß innerhalb einer Zeile der Tabelle die 4 Bits links in nicht permutierter und rechts in permutierter Form eingetragen sind. Mit anderen Worten, die 4 Bits C$_0$ bis C$_3$ in der Darstellung des linken Teils der Tabelle werden bei Anwendung der bijektiven Abbildungfunktion in die rechts in der Tabelle eingetragenen Permutationsbits P$_0$ bis P$_3$ transformiert. Etnsprechend werden bei der inversen bijektiven Abbildung die vier Permutationsbits mittels der Tabelle in ihre ursprünglichen Werte rückgewandelt.

Die Anforderung an die Permutationsbits P$_0$ bis P$_3$ und damit an die Eigenschaften der bijektiven Abbildungsfunktion sind dabei so gestaltet, daß sich nach Durchführung eines Inkrementiervorgangs statistisch gesehen nur jeweils eines der 4 Permutationsbits $P_0$ bis $P_3$ ändert.

Dies ist anhand der oben dargestellten Tabelle leicht nachvollziehbar.

In dem linken Teil der Tabelle sind die 4 nicht permutierten niederstwertigen Bits $C_0$ bis $C_3$ in 16 Zählschritten dargestellt.

In dem rechten Teil der Tabelle sind die gleichen Bits in permutierter Form als Permutationsbits $P_0$ bis $P_3$ dargestellt. Es zeigt sich dabei, daß sich von Datensatz zu Datensatz der Permutationsbits $P_0$ bis $P_3$ nach jedem Inkrementierungsvorgang nur 1 Bit ändert. So ändert sich beispielsweise von Zeile 1 zu Zeile 2 in der Darstellung gemäß der Tabelle nur das Bit $P_0$. Von Zeile 2 zu Zeile 3 der Tabelle ändert sich wiederum nur das Bit $P_1$. Entsprechendes gilt für jeden der Zählschritte entsprechend der Tabelle. Für einen gesamten Zyklus von 16 Zählschritten kann weiterhin gesehen werden, daß sich jedes der Permutationsbits $P_0$ bis $P_3$ genau 4 Mal ändert. Damit ist also durch diese Permutation erreicht worden, daß sich nach jedem Zählschritt die 4 niederwertigsten Bits $C_0$ bis $C_3$ nach Anwendung der bijektiven Abbildungsfunktion in permutierter Form als Permutationsbits $P_0$ bis $P_3$ gleichmäßig häufig ändern und daß sich pro Zählschritt nur jeweils eines dieser Permutationsbits $P_0$ bis $P_3$ ändert.

Die in der Tabelle dargestellte Permutation der niederwertigsten Bits $C_0$ bis $C_3$ in die permutierten. Permutationsbits $P_0$ bis $P_3$ kann grundsätzlich durch Ausprobieren gewonnen werden, d. h die Gestaltung der Permutationsbits in dem rechten Teil der Tabelle kann im Prinzip beliebig konstruiert werden, solange die Permutationsbits $P_0$ bis $P_3$ die oben erläuterten Bedingungen erfüllen. Eine Angabe einer systematischen bzw. mathematischen Vorschrift zur Gewinnung der bijektiven Abbildungsfunktion hat sich als nicht möglich erwiesen. Es ist keine allgemeine mathematische Formulierung bekannt, die allgemeingültig die Gewinnung einer solchen bijektiven Abbildungsvorschrift angeben konnte.

Eine halbwegs systematische Möglichkeit zu einer Folge von Datenworten der Permutationsbits $P_0$ bis $P_3$ zu kommen, wie sie in dem rechten Teil der Tabelle dargestellt sind, ist die Anwendung eines Suchbaumes. In einem Suchbaum wird ausgehend beispielsweise von dem ersten Datenwort der Permutationsbits mit den Bits 0000 ein Suchbaum aufgebaut, in dem in jeder neuen Ebene des Suchbaumes neue Datenworte eingetragen werden, in denen sich jeweils ausgehend von dem Permutationswort der vorherigen Ebene nur 1 Bit geändert hat. Auf diese Weise werden immer wieder neue Ebenen aufgebaut, in denen Permutationsworte stehen, in den sich jeweils nur 1 Bit gegenüber der vorherigen Ebene verändert hat. Auf diese Weise kann ein Suchbaum aufgebaut werden, entlang dessen Zweigen Permutationsworte entsprechend des rechten Teils der Tabelle gebildet werden. Dabei ist jedoch zu beachten, daß pro Zweig des Suchbaums für jedes permutierte Bit die Änderungshäufigkeit über alle bisherigen Suchbaumebenen, beginnend mit der Wurzel, notiert wird. Dabei ist die maximal erlaubte Änderungshäufigkeit für jedes Bit gleich dem auf die nächst größere gerade Zahl aufgerundeten Quotienten aus der Anzahl der Zählschritte, dividiert durch die Anzahl der Permutationsbits. Bei 4 Permutationsbits und damit möglichen 16 Zählschritten ergibt sich also ein Wert von 4 für die maximale Änderungshäufigkeit. Wird diese überschritten, so wird die Suche in diesem Zweig des Baumes abgebrochen. Ferner werden in jeder Ebene der Zweige des Suchbaums diejenigen Permutationsworte strichen, die in höheren Ebenen in dem Zweig bereits vorkamen. Somit werden bereits beim Aufbau des Suchbaumes einige Zweige nicht mehr in Frage kommen und beendet wenden, da sie diese Vorschriften nicht erfüllen. Nach vollständigem Aufbau des Suchbaumes werden sich jedoch auch Zweige ergeben, die diese Bedingungen erfüllen. Die Permutationsworte entlang dieser Zweige stellen dann die Permutationsworte in dem rechten Teil der Tabelle dar. Beispielsweise für 4 Permutationsbits sind dies 16 Datenworte, die sich dann entlang eines Zweiges des Suchbaums befinden. Diese Permutationsworte werden dann entsprechend der oben dargestellten Tabelle als bijektive Abbildungsfrunktion angewendet. Dies bedeutet nichts anderes, als daß die Permutationsworte wie oben für die Tabelle erläutert, die ursprünglichen niederwertigsten Bits $C_0$ bis $C_3$ nach Maßgabe der Tabelle ersetzen.

Die Anwendung der Suchbaumstrategie gestattet es somit, zu den Permutationsdatenworten auf systematische Weise zu gelangen. Die bijektive Abbildungsfunktion ergibt sich dann entsprechend der Darstellung der oben genannten Tabelle in der Weise, daß für jede Konstellation der 4 niederwertigsten Bits $C_0$ bis $C_3$ eine entsprechende Konstellation der permutierten Bits $P_0$ bis $P_3$, also der Permutationsworte, vorgeschrieben ist.

Die erfindungsgemäße Anordnung kann vorteilhaft für FunkschlüsseL-Systeme für Fahrzeuge eingesetzt werden, die mit einem sogenannten Wechselcode-Verfahren arbeiten. Dabei wird ein genügend großer Zähler, in dem Ausführungsbeispiel 32 Bit, im Funkschlüssel mit jedem Tastendruck erhöht. Der binäre Wert des Zählers wird danach mit kryptographischen Methoden verschlüsselt. Diese so gewonnene verschlüsselte Information über den Zählerstand wird dann zum Fahrzeug übermittelt. Eine logische Einheit in dem Fahrzeug kann dann wiederum anhand der Kenntnis des aktuellen Zählerstandes und des kryptographischen Algorithmus die Korrektheit der übertragenen verschlüsselten Informationen verifizieren und entsprechende Funktionen auslösen. Ein derartiger Funkschlüssel arbeitet batteriebetrieben, weshalb der nichtflüchtige Speicher 1 entsprechend der Figur als EPROM ausgebildet ist, damit der Inhalt auch bei einem Batteriewechsel in dem Funkschlüssel nicht verloren geht. Derartige EEPROMs haben jedoch wiederum den Nachteil, daß die Anzahl der möglichen Schreibvorgänge begrenzt sind und damit auch die Lebensdauer eines solchen Systems. Die erfindungsgemäße Anordnung erlaubt beispielsweise bei Datenworten von 32 Bit und Speicherworten im EEPROM von 8 Bit, wie oben erläutert, eine Reduzierung der Schreibvorgänge um den Faktor 4 und somit eine entsprechende Verlängerung des Systems in dem Funkschlüssel.

**EP 1 293 938 B1**

**Patentansprüche**

1. Anordnung zur Realisierung eines Binärzählers zum De-oder Inkrementieren eines in einem nichtflüchtigen Speicher (1) gespeicherten teilweise permutierten Datenwortes, mit einem Zähler und einem Arbeitsspeicher (2), wobei ein Datenwort in dem nichtflüchtigen Speicher (1) in wenigstens zwei Speicherworten gespeichert ist, wobei die Anordnung für eine De- oder Inkrementierung eines in dem nichtflüchtigen Speicher (1) gespeicherten Datenwortes so gestaltet ist, dass sie

   - die Speicherworte des Datenwortes aus dem nichtflüchtigen Speicher (1) ausliest, in dem Arbeitsspeicher (2) ablegt und dabei eine inverse Umordnung von k Permutationsbits des Datenwortes vornimmt,
   - eine inverse bijektive Abbildungsfunktion auf die k Permutationsbits des Datenwortes anwendet,
   - das Datenwort de- oder inkrementiert,
   - eine bijektive Abbildungsfunktion auf die k Permutationsbits des Datenwortes anwendet,
   - eine Umordnung der k Permutationsbits vornimmt,
   - und für jedes Speicherwort prüft, ob sich dieses von dem in dem nichtflüchtigen Speicher (1) gespeicherten Speicherwort unterscheidet und nur diejenigen Speicherworte neu in dem nichtflüchtigen Speicher speichert, für die dies der Fall ist,

   wobei die bijektive Abbildungsfunktion so ausgelegt ist, daß sich die k niederwertigsten Bits des Datenwortes, die die k Permutationsbits darstellen, auf die die Abbildungsfunktion angewendet wird, nach Anwenden der Abbildungsfunktion in Folge der De- oder Inkrementierung möglichst selten und etwa gleich häufig ändern, und wobei die Umordnung so vorgenommen wird, daß die k Permutationsbits des Datenwortes im Arbeitsspeicher (2) auf k Speicherworte im flüchtigen Speicher verteilt werden.

2. Anordnung nach Anspruch 1,
   **dadurch gekennzeichnet,**
   **daß** die Umordnung in der Weise vorgenommen wird, daß diejenigen Permutationsbits, die ihre Positionen in den Speicherworten beim Umordnen verändern, ihre Position mit anderen Bits in den Speicherworten tauschen.

3. Anordnung nach Anspruch 1,
   **dadurch gekennzeichnet,**
   **daß** die Schrittweite beim De- oder Inkrementieren 1 beträgt und das die Zahl k der Permutationsbits gleich der Zahl der Speicherworte eines Datenwortes ist.

4. Anordnung nach Anspruch 1,
   **dadurch gekennzeichnet,**
   **daß** ein Datenwort 32 Bit und jedes Speicherwort 8 Bit aufweisen.

5. Anordnung nach Anspruch 1,
   **dadurch gekennzeichnet,**
   **daß** die bijektive Abbildungsfunktion so ausgelegt ist, daß mit jedem De- oder Inkrementiervorgang sich in dem Datenwort nur ein Bit ändert.

6. Anordnung nach Anspruch 1,
   **dadurch gekennzeichnet,**
   **daß** die bijektive Abbildungsfunktion in der Weise umgesetzt wird, daß für jeden möglichen Wert des Datenwortes das permutierte Datenwort in einer Tabelle abgelegt ist.

7. Anordnung nach Anspruch 1,
   **dadurch gekennzeichnet,**
   **daß** die bijektive Abbildungsfunktion in der Weise gewonnen wird, daß eine Suchbaumstrategie eingesetzt wird bei der

   - pro Suchbaumebene alle diejenigen möglichen neuen Permutationsworte, die die k Permutationsbits in permutierter Form enthalten, eingetragen werden, in denen gegenüber der nächsthöheren Suchbaumebene nur ein Bit im Permutationswort geändert wird,
   - für jedes Bit die Änderungshäufigkeit über alle Suchbaumebenen notiert wird, wobei die maximal zulässige Änderungshäufigkeit für jedes Bit gleich dem auf die nächstgrößere gerade Zahl aufgerundeten Quotienten aus

9

der Anzahl der Zählschritte, dividiert durch die Anzahl der Permutationsbits ist, der Anzahl der permutierten Bits ist,

- in jeder Ebene diejenigen permutierten Datenworte gestrichen werden, die in höheren Ebenen in dem Zweig bereits vorkamen,
- letztlich ein beliebiger der Zweige ausgewählt wird und die permutierten Datenworte liefert, der über alle möglichen Ebenen unter Einhaltung dieser Bedingungen aufgebaut werden kann.

**8.** Anwendung der Anordnung nach einem der Ansprüche 1 bis 7 für Fahrzeug-Zugangssysteme.

**9.** Anwendung der Anordnung nach einem der Ansprüche 1 bis 7 für Funkschlüssel in Fahrzeug-Zugangssystemen.

**Claims**

**1.** An arrangement for realizing a binary counter, for decrementing or incrementing a partly permuted data word which is stored in a non-volatile memory (1), which arrangement is provided with a counter and a working memory (2), a data word being stored in the form of at least two memory words in the non-volatile memory (1), which arrangement is structured for a decrementation or incrementation of a data word stored in the non-volatile memory (1) such that it:

- reads the memory words of the data word from the non-volatile memory (1) and stores these memory words in the working memory (2) while performing an inverse reordering of k permutation bits of the data word,
- applies an inverse bijective mapping function to the k permutation bits of the data word,
- decrements or increments the data word,
- applies a bijective mapping function to the k permutation bits of the data word,
- performs a reordering of the k permutation bits,
- and checks for each memory word whether it deviates from the memory word stored in the non-volatile memory (1) and stores only those memory words in the non-volatile memory again for which this is the case,

the bijective mapping function being designed such that the k least significant bits of the data word, which represent the k permutation bits whereto the mapping function is applied, change as infrequently as possible and approximately equally frequently due to the decrementing or incrementing after application of the mapping function, the reordering being performed in such a manner that the k permutation bits of the data word in the working memory (2) are distributed among k memory words in the volatile memory.

**2.** An arrangement as claimed in claim 1,
**characterized in that** the reordering is performed in such a manner that those permutation bits whose positions in the memory words change upon reordering change position with other bits in the memory words.

**3.** An arrangement as claimed in claim 1,
**characterized in that** the step width during decrementing or incrementing amounts to one and that the number k of permutation bits is equal to the number of memory words of a data word.

**4.** An arrangement as claimed in claim 1,
**characterized in that** a data word comprises 32 bits and each memory word comprises 8 bits.

**5.** An arrangement as claimed in claim 1,
**characterized in that** the bijective mapping function is conceived to be such that only one bit in the data word changes during every decrementing or incrementing operation.

**6.** An arrangement as claimed in claim 1,
**characterized in that** the bijective mapping function is formed in such a manner that for each feasible value of the data word the permuted data word is stored in a table.

**7.** An arrangement as claimed in claim 1,
**characterized in that** the bijective mapping function is derived by employing a search tree strategy in which:

- for each search tree level all those feasible new permutation words, containing the k permutation bits in permuted form, are entered in which only one bit is changed with respect to the next higher search tree level,

- for each bit the frequency of change over all search tree levels is noted, the maximum permissible frequency of change for each bit being equal to the quotient, rounded off to the next higher even number, of the number of counting steps divided by the number of permutation bits, being the number of permuted bits,
- at each level those permuted data words which already occurred at higher levels in the branch are deleted,
- finally an arbitrary one of the branches is selected so as to deliver the permuted data words which can be formed across all levels while satisfying said conditions.

8. The use of the arrangement as claimed in any of the claims 1 to 7 for vehicle access systems.

9. The use of the arrangement as claimed in one of the claims 1 to 7 for radio keys in vehicle access systems.

**Revendications**

1. Dispositif pour la réalisation d'un compteur binaire, pour la décrémentation ou l'incrémentation d'un mot-machine en mémoire dans une mémoire non volatile (1) et partiellement permuté, avec un compteur et une mémoire de travail (2), un mot-machine étant enregistré dans la mémoire non volatile (1) en au moins deux mots-mémoire, le dispositif pour une décrémentation ou une incrémentation d'un mot-machine en mémoire dans la mémoire non volatile (1) étant configuré de manière à

- extraire les mots-mémoire du mot-machine de la mémoire non volatile (1), à les déposer dans la mémoire de travail (2) en procédant ce faisant à un réarrangement inverse de k bits de permutation du mot-machine,
- appliquer une fonction de représentation bijective inverse aux k bits de permutation du mot-machine,
- décrémenter ou incrémenter le mot-machine,
- appliquer une fonction de représentation bijective aux k bits de permutation du mot-machine,
- procéder à un réarrangement des k bits de permutation,
- et à vérifier pour chaque mot-mémoire, s'il diffère du mot-mémoire enregistré dans la mémoire non volatile (1) et à uniquement enregistrer une nouvelle fois dans la mémoire non volatile ceux des mots-mémoire pour lesquels ceci est le cas,

la fonction de représentation bijective étant étudiée de manière à ce que les k bits des valeurs les plus faibles du mot-machine, qui représentent les k bits de permutation, pour lesquels la fonction de représentation est utilisée, se modifient si possible peu et à une fréquence à peu près égale après l'application de la fonction de représentation suite à la décrémentation ou à l'incrémentation, et le réarrangement étant réalisé de manière à ce que les k bits de permutation du mot-machine dans la mémoire de travail (2) sont répartis dans k mots-mémoire dans la mémoire volatile.

2. Dispositif selon la revendication 1, **caractérisé en ce que** le réarrangement est réalisé de manière à ce que ceux des bits de permutation dont les positions sont modifiées dans les mots-mémoire lors du réarrangement, échangent leurs positions avec d'autres bits dans les mots-mémoire.

3. Dispositif selon la revendication 1, **caractérisé en ce que** le pas lors de la décrémentation ou de l'incrémentation est de 1 et **en ce que** le nombre k des bits de permutation est égal au nombre de mots-mémoire d'un mot-machine.

4. Dispositif selon la revendication 1, **caractérisé en ce qu'**un mot-machine présente 32 bits et **en ce que** chaque mot-mémoire présente 8 bits.

5. Dispositif selon la revendication 1, **caractérisé en ce que** la fonction de représentation bijective est étudiée de manière à ce que, à chaque processus de décrémentation ou d'incrémentation, un seul bit se modifie dans le mot-machine.

6. Dispositif selon la revendication 1, **caractérisé en ce que** la fonction de représentation bijective est mise en oeuvre de manière à ce que, pour chaque valeur possible du mot-machine, le mot-machine permuté est déposé dans une table.

7. Dispositif selon la revendication 1, **caractérisé en ce que** la fonction de représentation bijective est obtenue **en ce qu'**une stratégie à arborescence est utilisée avec laquelle

- par plan d'arborescence, on enregistre tous ceux des nouveaux mots de permutation possibles contenant les k bits de permutation sous forme permutée, dans lesquels on modifie seulement un bit dans le mot de permutation en comparaison au plan d'arborescence plus élevé suivant,

- pour chaque bit, la fréquence des modifications sur tous les plans d'arborescence étant notée, moyennant quoi la fréquence des modifications maximale autorisée pour chaque bit est égale au quotient arrondi au nombre pair supérieur le plus proche du nombre de pas de comptage, divisé par le nombre de bits de permutation, du nombre des bits permutés,

- dans chaque plan, ceux des mots-machines permutés étant supprimés, lesquels sont déjà apparus dans les plans plus élevés de la branche,

- une branche quelconque étant finalement choisie et délivrant les mots-machine permutés, laquelle peut être formée sur tous les plans possibles en respectant ces conditions.

8. Utilisation du dispositif selon l'une quelconque des revendications 1 à 7 pour des systèmes d'accès à des véhicules.

9. Utilisation du dispositif selon l'une quelconque des revendications 1 à 7 pour des clés à télécommande par radio de systèmes d'accès à des véhicules.

**IN DER BESCHREIBUNG AUFGEFÜHRTE DOKUMENTE**

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

**In der Beschreibung aufgeführte Patentdokumente**

- US 5450460 A

- US 6084935 A